## Europäisches Patentamt
## European Patent Office
## Office européen des brevets

(19)

(11) Veröffentlichungsnummer : **0 116 160
B1**

(12) **EUROPÄISCHE PATENTSCHRIFT**

(45) Veröffentlichungstag der Patentschrift :
23.12.87

(21) Anmeldenummer : **83112867.3**

(22) Anmeldetag : **21.12.83**

(51) Int. Cl.⁴ : **F 01 D 25/16**, F 01 D 25/26//
**F02C6/12**

(54) **Aussengelagerter Abgasturbolader mit ungekühltem Gaskanal.**

(30) Priorität : **18.01.83 CH 263/83**

(43) Veröffentlichungstag der Anmeldung :
**22.08.84 Patentblatt 84/34**

(45) Bekanntmachung des Hinweises auf die Patenterteilung : **23.12.87 Patentblatt 87/52**

(84) Benannte Vertragsstaaten :
**CH DE FR GB LI**

(56) Entgegenhaltungen :
**BE-A-  435 519
DE-A- 2 211 869
DE-C-   806 925
DE-C-   926 665
DE-C-   972 115
DE-C- 1 144 538
GB-A-   698 539
US-A- 3 117 826
US-A- 4 304 522
Die Akte enthält technische Angaben, die nach dem
Eingang der Anmeldung eingereicht wurden und die
nicht in dieser Patentschrift enthalten sind.**

(73) Patentinhaber : **BBC Aktiengesellschaft Brown,
Boveri & Cie.
Haselstrasse
CH-5401 Baden (CH)**

(72) Erfinder : **Hörler, Hansulrich, Dr.
Lerchenberg 5
CH-8046 Zürich (CH)**
Erfinder : **Perego, Ambrogio
Bahnhofstrasse 103D
CH-5430 Wettingen (CH)**

EP 0 116 160 B1

## Beschreibung

Die Erfindung bezieht sich auf eine axial durchströmte Turbine mit ungekühltem Gaskanal gemäss Oberbegriff des Patentanspruchs 1.

Um unerwünschte thermische Spannungen und zu hohe Oberflächentemperaturen zu vermeiden, wird der Gaskanal grosser Abgasturbolader meistens wassergekühlt. Hingegen weisen Abgasturbolader mit ungekühltem Gaskanal thermodynamische Vorteile auf. Die Bedingung ist dabei, dass die Gehäuseaussentemperatur aus Sicherheitsgründen unterhalb ca. 200 °C bleibt. Durch Wegfall der im Kühlwasser abgeführten Wärmemenge wird dem Abgas eines ungekühlten Turboladers bis zum Turbinenaustritt weniger Wärme entzogen. Da die obere Prozesstemperatur höher liegt, steigt der thermische Wirkungsgrad der Turbine und somit bei gleichbleibender Abgasmenge die an den Luftverdichter abgegebene Leistung. Bei Diesel-Anlagen, die mit einem Abhitzekessel ausgerüstet sind, steht damit Abwärme auf einem um ca. 10 bis 15 °C höheren Temperaturniveau zur Verfügung.

Da die Temperatur des Heissgasgehäuses im Bereiche über 500 °C liegt, entstehen wegen den verschiedenen Wärmedehnungen stationäre und instationäre thermische Spannungen und dadurch konstruktive Probleme in bezug auf die Abstützung des Heissgasgehäuses im Traggehäuse eines ungekühlten Abgasturboladers.

Eine Turbine der eingangs genannten Art ist bekannt aus der DE-C-972 115. Das in Radialrichtung nachgiebige ringförmige Abstützelement besteht dort aus einer Kombination eines gebogenen Bleches und radial gerichteter Bolzen, über die der heisse Einführungsstutzen mit Flanschen und Schrauben am Traggehäuse, dort eine schildartige Wand, befestigt ist. Zur Vermeidung von Axialverschiebungen sind in einer andern Ebene weitere radiale Bolzen zwischen Einführungsstutzen und Traggehäuse vorgesehen.

Der Erfindung liegt die Aufgabe zu Grunde, bei einer Gasturbine der eingangs genannten Art eine Verbindung zwischen dem Heissgasgehäuse und dem Traggehäuse zu schaffen, die eine gute Zentrierung und eine geringe Wärmeableitung zum Traggehäuse gewährleistet.

Erfindungsgemäss wird diese Aufgabe mit den kennzeichnenden Merkmalen des Patentanspruches 1 gelöst.

Abgesehen von der Materialwahl sind derartige Abstützelemente bekannt aus der US-A-3 117 826. Sie weisen die Form von dünnwandigen, achssymmetrischen Kegelstümpfen auf, die über ein Verstärkungselement miteinander verbunden sind. Sie sind dort Bestandteil der eintrittsseitigen Rotorlagerung eines Gasturbinenverdichters.

Die durch die Erfindung erreichten Vorteile sind im wesentlichen darin zu sehen, dass eine einfache, gasdichte und betriebssichere Verbindung des Heissgasgehäuses mit dem Traggehäuse geschaffen ist, bei welcher eine relativ niedrige Aussentemperatur des Trag- und Abgasgehäuses gewährleistet wird. Die Verbindung ist ausserdem spiel- und dadurch klapperfrei. Sowohl beim Anfahren als auch im Normalbetrieb auftretende thermische Spannungen bleiben in zulässigen Grenzen. Somit werden das Kriechen des Materials und die Verschleisserscheinungen weitgehend entschärft. Da die Wärmedehnzahl des Werkstoffes der Membranflanken um 5 % bis 40 % höher ist als jene des Werkstoffes des Heissgasgehäuses, wird ein Abbau der in der Innenflanke der Membrane in der Nähe des Innenflansches auftretenden Wärmespannungen während der Anfahrperiode erreicht.

Wenn die Falte gegenüber den Membranflanken verstärkt ist, wird die lokale Spannungskonzentration wesentlich reduziert. Dies hat einen positiven Einfluss auf die Ermüdungserscheinungen im Werkstoff und somit auf die Lebensdauer des Abstützungselementes.

In der Zeichnung sind zwei Ausführungsbeispiele des Erfindungsgegenstandes vereinfacht dargestellt.

Es zeigen :

Fig. 1 die Turbine eines Abgasturboladers im Längsschnitt ;

Fig. 2 eine erste Ausführungsform der Verbindung zwischen Heissgas- und Traggehäuse ;

Fig. 3 eine Abwandlung der Verbindung gemäss Fig. 2.

Gleiche Teile sind in den Figuren mit denselben Bezugszeichen versehen. Die Strömungsrichtung des Arbeitsmittels ist mit Pfeilen bezeichnet. Erfindungsunwesentliche Teile des Abgasturboladers wie beispielsweise Luftfilter, Luftverdichter, Turbinenabgaskanal, Konsolen und Befestigungselemente sind weggelassen.

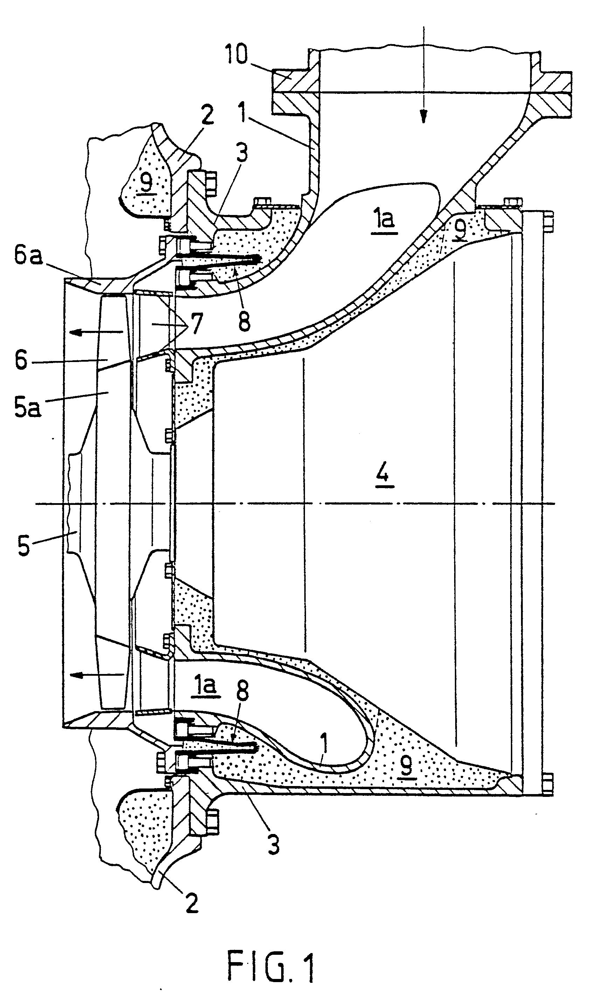

Die in Fig. 1 dargestellte Axialturbine eines Abgasturboladers mit ungekühltem Gaskanal ist über ein Heissgasgehäuse 1 an die Auspuffleitung 10 eines nicht gezeigten aufgeladenen Diesel-Motors angeschlossen. Im Heissgasgehäuse 1 ist ein Heissgaskanal 1a angeordnet. Die Turbinenwelle 5 ist in einem Lagergehäuse 4 auf bekannte Weise gelagert und trägt die mit Turbinenlaufschaufeln 6 versehene Scheibe 5a. Das Heissgasgehäuse 1 ist mittels einer Schraubenverbindung mit dem Traggehäuse 3 und dieses wiederum mit dem Abgasgehäuse 2 auf gleiche Weise verbunden. Das Lagergehäuse 4 ist an das Traggehäuse 3 mittels Schrauben befestigt und trägt die hier nicht gezeigten Lager der Turbinenwelle 5 in sich.

Um die Betriebstemperatur des Abgasgehäuses 2, des Traggehäuses 3 und des Lagergehäuses 4 im gewünschten Rahmen halten zu können, werden die Hohlräume zwischen Heissgasgehäuse 1, Traggehäuse 3 und Lagergehäuse 4, sowie die Innenseite des Abgasgehäuses 2 mit einer Wärmeisolation 9 versehen, die beispielsweise aus Mineralwolle besteht. Ein Leitschaufelkranz 7 ist an der der Turbine zugewandten Stirnfläche des Heissgasgehäuses 1 befestigt. Ein Turbinenabdeckring 6a ist mit dem Traggehäuse 3 verbunden.

Die Betriebstemperatur des Heissgasgehäuses 1 beträgt ca. 500 °C und mehr. Aus Sicherheitsgründen darf die Aussentemperatur des Traggehäuses 3 sowie die des Abgasgehäuses 2 den Wert 200 °C nicht überschreiten. Beim Start erwärmt sich das Heissgasgehäuse relativ schnell und gegenüber dem Traggehäuse entsteht vorübergehend eine Temperaturdifferenz bis zu 400 °C, die im Normalbetrieb auf einen Wert von ca. 300 °C sinkt.

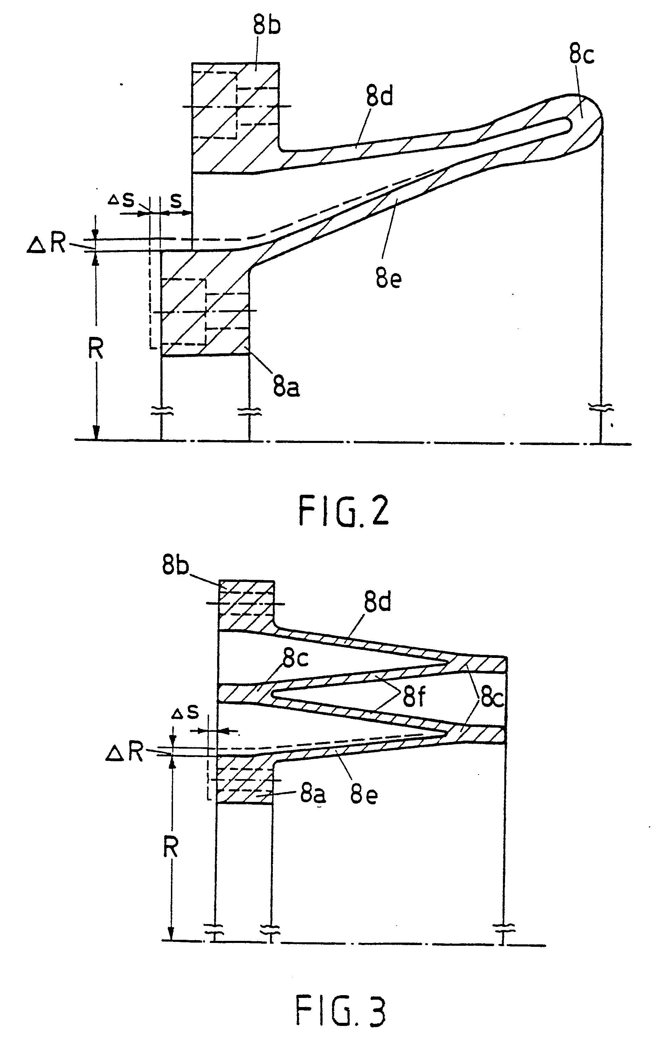

Soweit sind Abgasturbolader mit ungekühltem Gaskanal bekannt. Gemäss der Erfindung ist nun das Heissgasgehäuse 1 mittels einem in Fig. 2 näher dargestellten, in Radialrichtung nachgiebigen, ringförmigen Abstützungselement 8 mit dem Traggehäuse 3 verbunden. Das Abstützungselement 8 weist mindestens zwei vorwiegend in axialer Richtung verlaufende Membranflanken 8d, 8e auf, die einerseits über eine Falte 8c miteinander verbunden sind und andererseits über jeweils einen Flansch 8a, 8b am Heissgasgehäuse 1 bzw. Traggehäuse 3 befestigt sind, wobei die Flansche 8a, 8b mindestens annähernd in der gleichen Radialebene liegen. Um die direkte Wärmeübertragung von einem auf den anderen Flansch zu vermeiden, wird der schmale Raum zwischen den beiden Flanken 8d und 8e thermisch isoliert. Zwischen dem Turbinenabdeckring 6a und dem Leitschaufelkranz 7 ist im kalten Zustand ein Axialspiel vorhanden, um die infolge der Temperatur- und/oder Kräfteeinflüsse auftretende axiale Verschiebung des Leitschaufelkranzes 7 zu ermöglichen.

Die der Turbine zugewandte Stirnfläche des Heissgasgehäuses 1 darf sich durch Temperatur- und/oder Kräfteeinflüsse axial gegenüber dem Traggehäuse 3 nur unwesentlich bewegen, damit der innen am Heissgasgehäuse 1 befestigte und aussen auf dem Turbinendeckring 6a im warmen Zustand aufliegende Leitschaufelkranz 7 nicht überbeansprucht wird. Dies bedingt unter anderem eine axial feste Verbindung des Heissgasgehäuses 1 mit dem Traggehäuse 3 nahe der der Turbine zugewandten Stirnfläche des Heissgasgehäuses 1.

Da der Ringraum ausserhalb des Leitschaufelkranzes 7 unter dem vollen Druck des Motorabgases und der mit der Wärmeisolation ausgefüllte Raum zwischen dem Heissgasgehäuse 1 und Traggehäuse 3 unter dem Umgebungsdruck steht, muss die Verbindung zwischen Heissgas- und Traggehäuse dicht sein.

Das nachgiebige Abstützungselement 8 gewährleistet die erforderliche Zentrierung des Heissgasgehäuses 1 im Traggehäuse 3, nimmt sämtliche an das Heissgasgehäuse 1 wirkenden statischen und dynamischen Kräfte auf, ermöglicht die relative Radialdehnung des Heissgasgehäuses 1 gegenüber dem Traggehäuse 3 und dichtet den Heissgaskanal nach aussen vollkommen ab.

Bei der in Fig. 2 gezeigten Variante eines Abstützungselementes 8 verläuft die Aussenflanke 8d von dem Aussenflansch 8b etwas kegelmantelförmig nach aussen und nach der Falte 8c verläuft die Innenflanke 8e kegelmantelförmig nach innen, zurück zu dem Innenflansch 8a. Die Membranflanken 8d, 8e, 8f bilden jeweils den Mantel eines Kegelstumpfes unterschiedlicher Neigung, wobei ihre der Turbine zugekehrten Enden auf dem kleineren Durchmesser liegen. Die Falte 8c ist zwecks Begrenzung der Biegespannung abgekröpft und weist eine grössere Stärke als die Membranflanken auf. Gestrichelt ist die Kontur des Innenteiles des Abstützungselementes 8 bei der Betriebstemperatur, schematisch mit einer axialen Wärmedehnung $\Delta S$ und einer radialen $\Delta R$ dargestellt. Die axiale Wärmedehnung $\Delta S$ entspricht etwa dem im kalten Zustand vorhandenen Axialspiel zwischen Turbinendeckring 6a und Leitschaufelkranz 7. Um eine Torsionsfestigkeit zu erreichen, sind die beiden Flansche 8a und 8b robust ausgeführt.

Eine allzu massive Ausführung des Innenflansches 8a sowie der Faltenpartie 8c ist wegen der thermischen Trägheit jedoch unerwünscht. Hingegen ist es erforderlich, dass sich die angenommene lineare Temperaturverteilung vom Innenflansch 8a zu dem Aussenflansch 8b bei transienten Vorgängen möglichst schnell einstellt. In diesem Falle lassen sich die im Abstützungselement 8 auftretenden Spannungen, die hauptsächlich aus der Belastung der Wärmedehnung des Heissgasgehäuses 1, ungleichmässiger eigener Wärmedehnung, sowie der an das Heissgasgehäuse 1 wirkenden Gaskräfte entstehen, unter der Elastizitätsgrenze des verwendeten Werkstoffes halten.

Die Wirkungsweise des Abgasturboladers geht aus folgendem hervor : Das Abgas strömt durch den Heissgaskanal 1a und den Leitschaufelkranz 7 zu den Turbinenlaufschaufeln 6, in denen es sich unter Abgabe von Leistung entspannt und anschliessend durch eine nicht gezeigte Abgasleitung in einen nicht gezeigten nachgeschalteten Anhitzekessel ausgestossen wird.

Da zwischen dem Heissgasgehäuse 1 und dem Innenflansch 8a ein guter thermischer Kontakt besteht, erwärmt und dehnt sich der Innenflansch 8a zusammen mit dem Heissgasgehäuse 1 beim Start des Motors radial, um den Wert $\Delta R$, gemessen auf dem Aussenradius R des Innenflansches 8a, relativ schnell aus.

Im stationären Betriebszustand des Motors stellt sich eine annähernd lineare Temperaturverteilung vom Innenflansch 8a über die Membrane 8e, 8c, 8d zum Aussenflansch 8b ein. Da die Innenflanke 8e wärmer ist als die Aussenflanke 8d, verschiebt sich der Innenflansch 8a infolge der Wärmedehnung in Richtung der Turbine um den Wert $\Delta S$, wodurch der Leitschaufelkranz an der dazu vorgesehene Stirnfläche des Turbinendeckringes 6a anliegt.

Der Innenflansch 8a hat gegenüber dem Aussenflansch 8b in diesem Falle einen Ueberstand S. Dementsprechend weisen die beiden Flanken 8d und 8e ungleiche Längen auf. Die Länge der Flanken 8d, 8e spielt in bezug auf axiale Wärmedehnung $\Delta S$ eine Rolle. Grundsätzlich kann die Länge der Innenflanke 8e grösser oder kleiner als diejenige der Aussenflanke 8d sein. In Abhängigkeit vom Längenverhältnis der Aussen- zu der Innenflanke kann die axiale Wärmedehnung $\Delta S$ entweder einen endlichen positiven Wert in der Richtung der Turbine aufweisen, oder Null sein, wenn die Innenflanke 8e dementsprechend kürzer als die Aussenflanke 8d ist.

Die beiden Flansche 8a und 8b sind mit Schraubenlöchern für die Befestigung des Abstützungselementes 8 an das Heissgasgehäuse 1 bzw. Traggehäuse 3 versehen.

Die Form des Abstützungselementes 8 kann beispielsweise durch Giessen oder durch zweiteiliges Drehen und anschliessendes Elektronenstrahlschweissen im Bereiche der Falte 8c hergestellt werden. Um zumindest im stationären Betrieb den konstanten Temperaturabfall über die ganze Länge der Membrane 8c, 8d, 8e zu erhalten, ist die Membrane allseitig mit einer Wärmeisolation 9 versehen.

In bezug auf die Betriebstemperaturen und die auftretenden Spannungen soll für das Abstützzungselement ein legierter Stahl gewählt werden. Eine Reduktion der Wärmespannungen vor allem während der Anfahrperiode im Bereiche des Innenflansches 8a und Innenflanke 8e wird erzielt, wenn die Wärmedehnzahl des Werkstoffes der Membranflanken 8d, 8e um 5 % bis 40 % höher ist als jene des Werkstoffes des Heissgasgehäuses 1.

In Fig. 3 ist eine weitere Ausführung des Abstützzungselementes 8 mit drei Falten 8c und vier Flanken 8d, 8e, 8f gezeigt, wobei die beiden Flansche 8a und 8b in der gleichen Radialebene liegen.

Wenn die Membrane 8c, 8d, 8e, 8f des Abstützzungselementes 8 mehr als eine Falte 8c aufweist, erreicht man den Vorteil, dass nebst geringeren Wärmespannungen, die axiale Wärmedehnung $\Delta S$ der der Turbine zugewandten Stirnfläche des Heissgasgehäuses in der Richtung des Turbinenrotors geringer ist. Dies aus dem Grunde, dass die Länge der für die axiale Wärmedehnung ausschlaggebende Flanke 8e im Vergleich zu jener eines Abstützungselementes mit einer Falte und zwei Flanken relativ geringer ist. In Abhängigkeit von der Konstruktion des Trag- 3 und Heissgasgehäuses 1 ist eine Ausführung des Abstützungselementes 8 auch mit zwei Falten 8c und dementsprechend drei Flanken 8d, 8e, 8f möglich. In diesem Falle liegen die beiden Flansche 8a und 8b in zwei verschieden um die Flankenlänge voneinander entfernten Radialebenen.

Der Vorteil der Erfindung wird insbesondere darin gesehen, dass durch die unmittelbare Verbindung des Heissgasgehäuses 1 mit dem Traggehäuse 3 durch ein nachgiebiges Abstützzungselement 8 nebst guter Zentrierung und Gasdichtheit, eine relativ geringe Wärmeabfuhr an das Traggehäuse 3 und somit eine relativ niedrige Aussentemperatur erreicht wird. Stationäre und instationäre thermische Spannungen sowie Abnutzungserscheinungen werden weitgehend beherrscht und damit wird die Lebensdauer des Turboladers positiv beeinflusst.

Selbstverständlich umfasst die Erfindung beispielsweise auch andere Typen von Turbomaschinen, bei welchen infolge der Abstützung eines heissen Gehäuses in einem Kaltgehäuse konstruktive Probleme in bezug auf radiale Differenzdehnung entstehen.

Bezeichnungsliste

| | |
|---|---|
| 1 | Heissgasgehäuse |
| 1a | Heissgaskanal |
| 2 | Abgasgehäuse |
| 3 | Traggehäuse |
| 4 | Lagergehäuse |
| 5 | Turbinenwelle |
| 5a | Scheibe |
| 6 | Turbinenlaufschaufeln |
| 6a | Turbinenabdeckring |
| 7 | Leitschaufelkranz |
| 8 | Abstützungselement |
| 8a | Innenflansch |
| 8b | Aussenflansch |
| 8c | Falte |
| 8d | Aussenflanke |
| 8e | Innenflanke |
| 8f | Zwischenflanke |
| 9 | Wärmeisolation |
| 10 | Auspuffleitung |
| S | Ueberstand |
| $\Delta S$ | axiale Wärmedehnung |
| R | Aussenradius des Innenflansches |
| $\Delta R$ | Radiale Wärmedehnung |

**Patentansprüche**

1. Axial durchströmte Turbine mit ungekühltem Gaskanal und starrem Traggehäuse (3), bei der das Heissgasgehäuse (1) im Traggehäuse (3) abgestützt ist, derart, dass es radial dehnbar ist, wobei die Verbindung zwischen Heissgasgehäuse (1) und Traggehäuse (3) ein in Radialrichtung nachgiebiges ringförmiges Abstützungselement (8) ist, dadurch gekennzeichnet, dass das Abstützzungselement (8) mindestens zwei in axialer Richtung verlaufende Membranflanken (8d, 8e, 8f) aufweist, die einerseits über eine Falte (8c) miteinander verbunden sind und andererseits über jeweils einen Flansch (8a, 8b) am Heissgasgehäuse (1) bzw. Traggehäuse (3) befestigt sind, wobei die Werkstoff-Wärmedehnzahl der Membranflanken (8d, 8e, 8f) um 5 bis 40 % höher als jene des Heissgasgehäuses (1) ist.

2. Axial durchströmte Turbine nach Anspruch 1, dadurch gekennzeichnet, dass die Membranflanken (8d, 8e, 8f) an der der Turbine abgewandten Seite und die Flansche (8a, 8b) an der der Turbine zugewandten Seite des Abstützungselementes (8) vorgesehen sind.

3. Axial durchströmte Turbine nach Anspruch 1, dadurch gekennzeichnet, dass die Membranflanken (8d, 8e, 8f) jeweils den Mantel eines Kegelstumpfes unterschiedlicher Neigung bilden, wobei ihre der Turbine zugekehrten Enden auf dem kleineren Durchmesser liegen.

4. Axial durchströmte Turbine nach Anspruch 1, dadurch gekennzeichnet, dass die Falte (8c) zwecks Begrenzung der Biegespannung abgekröpft ist und eine grössere Stärke aufweist als die Membranflanken (8d, 8e, 8f).

## Claims

1. Axial flow turbine with uncooled gas duct and rigid load-carrying casing (3), in which turbine the hot gas casing (1) is supported in the load-carrying casing (3) in such a way that it can expand radially, the connection between the hot gas casing (1) and the load-carrying casing (3) being an annular support element (8) which is flexible in the radial direction, characterised in that the support element (8) has at least two diaphragm flanks (8d, 8e, 8f) extending in the axial direction, which flanks are connected together at one end by a fold (8c) and are fastened at the other end by means of flanges (8a, 8b) to the hot gas casing (1) and the load-carrying casing (3), respectively, the material thermal expansion coefficient of the diaphragm flanks (8d, 8e, 8f) being 5 % to 40 % higher than that of the hot gas casing (1).

2. Axial flow turbine according to claim 1, characterised in that the diaphragm flanks (8d, 8e, 8f) are provided at the end of the support element (8) facing away from the turbine and the flanges (8a, 8b) are provided at the end of the support element (8) facing towards the turbine.

3. Axial flow turbine according to Claim 1, characterised in that each of the diaphragm flanks (8d, 8e, 8f) forms the outer surface of truncated cone, each with a different slope, the ends facing towards the turbine being located on the smaller diameter.

4. Axial flow turbine according to Claim 1, characterised in that the fold (8c) is bent round and has a greater thickness than the diaphragm flanks (8d, 8e, 8f) in order to limit the bending stress.

## Revendications

1. Turbine axiale à conduit de gaz non refroidi et à carter de support (3) rigide, dans laquelle le carter à gaz chaud (1) est monté dans le carter de support (3), d'une manière telle qu'il puisse se dilater radialement, le raccordement entre le carter à gaz chaud (1) et le carter de support (3) étant assuré par un élément de support annulaire (8) souple dans le sens radial, caractérisée en ce que l'élément de support (8) comporte au moins deux flancs de membrane (8d, 8e, 8f) qui s'étendent dans le sens axial, qui, d'une part, sont reliés l'un à l'autre par un pli (8c) et, d'autre part, sont fixés chaque fois, par l'intermédiaire d'une bride respective (8a, 8b), au carter à gaz chaud (1) et au carter de support (3), le coefficient de dilatation thermique du matériau des flancs de membrane (8d, 8e, 8f) étant supérieur de 5 à 40 % à celui du carter à gaz chaud (1).

2. Turbine axiale suivant la revendication 1, caractérisée en ce que les flancs de membrane (8d, 8e, 8f) sont prévus du côté de l'élément de support (8) opposé à la turbine et les brides (8a, 8b) sont prévues de son côté tourné vers la turbine.

3. Turbine axiale suivant la revendication 1, caractérisée en ce que les flancs de membrane (8d, 8e, 8f) forment chaque fois l'enveloppe de troncs de cônes d'inclinaisons différentes, leurs extrémités tournées vers la turbine se trouvant sur le petit diamètre.

4. Turbine axiale suivant la revendication 1, caractérisée en ce que le pli (8c) est coudé pour limiter la contrainte de flexion et présente une épaisseur supérieure à celle des flancs de membrane (8d, 8e, 8f).

FIG. 1

1

FIG.2

FIG.3